(19)

Europäisches
Patentamt
European
Patent Office
Office européen
des brevets

(11) **EP 4 148 994 A1**

(12) **EUROPEAN PATENT APPLICATION**

(43) Date of publication:
**15.03.2023 Bulletin 2023/11**

(21) Application number: **22190440.2**

(22) Date of filing: **15.08.2022**

(51) International Patent Classification (IPC):
$H03G\ 3/30^{(2006.01)}$     $H03F\ 1/56^{(2006.01)}$
$H04B\ 1/06^{(2006.01)}$     $H04B\ 1/18^{(2006.01)}$

(52) Cooperative Patent Classification (CPC):
**H03F 1/56; H03G 3/3036; H04B 1/06; H04B 1/18**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.09.2021   US 202163243613 P
23.05.2022   US 202217750909**

(71) Applicant: **Apple Inc.
Cupertino CA 95014 (US)**

(72) Inventors:
• **KONG, Long
Campbell (US)**
• **GAMBINI, Simone
San Francisco (US)**
• **SECKIN, Utku
San Jose (US)**

(74) Representative: **Froud, Christopher Andrew
Withers & Rogers LLP
2 London Bridge
London SE1 9RA (GB)**

(54) **AMPLIFIER CIRCUITRY WITH GAIN ADJUSTMENTS AND INPUT MATCHING**

(57)     There is provided amplifier circuitry (52) comprising: an amplifier (70) having an input coupled to an antenna (42) and having an output; an adjustable load component ($Z_L$) having a first terminal coupled to the output of the amplifier (70) and having a second terminal coupled to a ground power supply line (62); an adjustable feedback component ($Z_F$) having a first terminal coupled to the output of the amplifier (70) and having a second terminal coupled to the input of the amplifier (70); and a gain and impedance matching control circuit (72) having an output coupled to the adjustable load component ($Z_L$) and the adjustable feedback component ($Z_F$).

EP 4 148 994 A1

*FIG. 8*

## Description

This application claims priority to U.S. patent application No. 17/750,909, filed May 23, 2022, and U.S. provisional patent application No. 63/243,613, filed September 13, 2021, which are hereby incorporated by reference herein in their entireties.

### Field

This disclosure relates generally to electronic devices and, more particularly, to electronic devices with wireless communications circuitry.

### Background

Electronic devices are often provided with wireless communications capabilities. An electronic device with wireless communications capabilities has wireless communications circuitry with one or more antennas. Wireless receiver circuitry in the wireless communications circuitry uses the antennas to receive radio-frequency signals.

Signals received by the antennas are fed through a radio-frequency front-end module, which often includes a low noise amplifier for amplifying the received radio-frequency signals. It can be challenging to design satisfactory low noise amplifier circuitry for an electronic device.

### Summary

An electronic device may include wireless communications circuitry configured to receive radio-frequency signals from one or more base stations. The wireless communications circuitry may include an antenna, transceiver circuitry configured to receive radio-frequency signals from the antenna and to generate corresponding baseband signals, and a processor configured to receive the baseband signals from the transceiver circuitry. The wireless communications circuitry may further include amplifier circuitry disposed on a radio-frequency transmission line path between the antenna and the transceiver circuitry. The amplifier circuitry may include low noise amplifier circuitry configured to amplify radio-frequency signals received from the antenna.

An aspect of this disclosure provides amplifier circuitry that includes an amplifier having an input coupled to an antenna and having an output, an adjustable load component having a first terminal coupled to the output of the amplifier and having a second terminal coupled to a ground power supply line, an adjustable feedback component having a first terminal coupled to the output of the amplifier and having a second terminal coupled to the input of the amplifier, and a gain and impedance matching control circuit having an output coupled to the adjustable load component and the adjustable feedback component. The adjustable load component and the adjustable feedback component can be the same type or different types of electrical components. The adjustable load component may be an adjustable load capacitance, an adjustable load inductance, or an adjustable load resistance. The adjustable feedback component may be an adjustable feedback capacitance, an adjustable feedback inductance, or an adjustable feedback resistance. The gain and impedance matching control circuit can be configured to control a gain of the amplifier circuitry by adjusting the adjustable load component while maintaining an input resistance of the amplifier circuitry at a target level by adjusting the adjustable feedback component. The gain and impedance matching control circuit can be configured to generate control signals at its output for adjusting a gain of the amplifier circuitry without changing an amount of current flowing through the amplifier. The gain and impedance matching control circuit can be configured to set a ratio (or product) of a value of the adjustable load component to a value of the adjustable feedback component to a predetermined constant across different gain modes. The amplifier can have an output impedance that is at least two times greater than an impedance of the adjustable load component. The amplifier can be a transconductance amplifier having an output impedance that is at least five times greater than the impedance of the adjustable load component.

An aspect of this disclosure provides a method of operating amplifier circuitry. The method can include receiving at an input of an amplifier a radio-frequency signal, outputting at an output of the amplifier an amplified signal to a mixer, and adjusting an adjustable load component coupled to the output of the amplifier to tune a gain of the amplifier circuitry while adjusting an adjustable feedback component coupled across the output and the input of the amplifier to set an input resistance of the amplifier circuitry. The method can include tuning the gain of the amplifier circuitry without changing a transconductance of the amplifier. The method can include setting a ratio of a value of the adjustable load component to a value of the adjustable feedback component to a predetermined constant when the amplifier circuitry is operated across different gain modes (settings). The adjustable load component and the adjustable feedback component can be the same type or different types of adjustable electrical components.

An aspect of this disclosure provides an electronic device that includes an antenna configured to receive radio-frequency signals, a transceiver configured to generate baseband signals based on the radio-frequency signals, a processor configured to receive the baseband signals, and amplifier circuitry configured to receive the radio-frequency signals from the antenna and to output corresponding amplified signals to the transceiver. The amplifier circuitry can include an amplifier having an input and an output with an output impedance, an adjustable load capacitance having a first terminal coupled to the output of the amplifier and having a second terminal coupled to a ground line, the adjustable load capacitance having a load impedance that is smaller than the output impedance of the amplifier, an adjustable feedback capacitance having a first terminal coupled to the output of the amplifier and having a second terminal coupled to the input of the amplifier, and a gain and impedance matching control circuit coupled to the adjustable load capacitance and the adjustable feedback capacitance.

## Brief Description of the Drawings

FIG. 1 is a diagram of an illustrative electronic device with wireless communications circuitry in accordance with some embodiments.
FIG. 2 is a diagram of illustrative wireless communications circuitry having a front-end module coupled between antennas and transceiver circuitry in accordance with some embodiments.
FIG. 3 is a diagram of illustrative amplifier circuitry with an adjustable capacitive network for gain control and input matching in accordance with some embodiments.
FIG. 4 is a table showing illustrative capacitor values corresponding to different amplifier gain settings in accordance with some embodiments.
FIG. 5 is a diagram of an illustrative adjustable capacitor circuit in accordance with some embodiments.
FIG. 6 is a diagram of illustrative amplifier circuitry with an adjustable resistive network for gain control and input matching in accordance with some embodiments.
FIG. 7 is a diagram of illustrative amplifier circuitry with an adjustable inductive network for gain control and input matching in accordance with some embodiments.
FIG. 8 is a diagram of illustrative amplifier circuitry with an adjustable load network for gain control and input matching in accordance with some embodiments.
FIG. 9 is a flow chart of illustrative steps for operating amplifier circuitry of the type shown in FIGS. 3, 6, 7, and 8 in accordance with some embodiments.

## Detailed Description

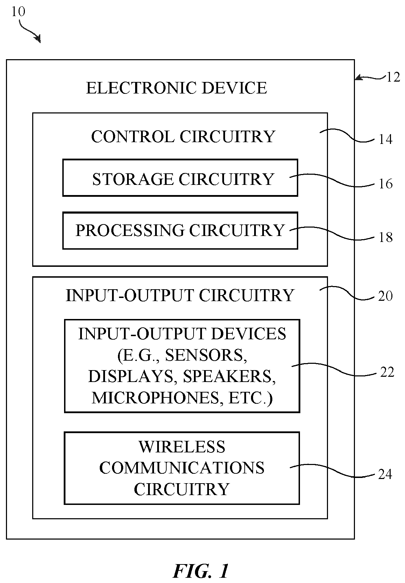

An electronic device such as electronic device 10 of FIG. 1 may be provided with wireless circuitry. The wireless circuitry may include an amplifier such as low noise amplifier circuitry configured to amplify radio-frequency signals in the receive (downlink) path. The low noise amplifier (LNA) circuitry may include an amplifier having an input coupled to an antenna and an output coupled to a mixer, an adjustable load capacitance coupled to the output of the LNA circuitry, an adjustable feedback capacitance coupled across the input and output of the LNA circuitry, and an associated control circuit for adjusting the adjustable load capacitance and the adjustable feedback capacitance. The control circuit may be configured to adjust the load capacitance to tune the gain of the LNA circuitry while adjusting the feedback capacitance to maintain input impedance matching for the LNA circuitry. The operating current or voltage in the amplifier need not be changed to tune the gain of the LNA circuitry. The adjustable load capacitance may alternatively be implemented as an adjustable load inductance or an adjustable load resistance. The adjustable feedback capacitance may alternatively be implemented as an adjustable feedback inductance or an adjustable feedback resistance. Configured and operated in this way, the gain of the LNA circuitry can be adjusted while maintaining the input resistance without negatively impacting the overall noise figure of the LNA circuitry.

Electronic device 10 of FIG. 1 may be a computing device such as a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses or other equipment worn on a user's head, or other wearable or miniature device, a television, a computer display that does not contain an embedded computer, a gaming device, a navigation device, an embedded system such as a system in which electronic equipment with a display is mounted in a kiosk or automobile, a wireless internet-connected voice-controlled speaker, a home entertainment device, a remote control device, a gaming controller, a peripheral user input device, a wireless base station or access point, equipment that implements the functionality of two or more of these devices, or other electronic equipment.

As shown in the schematic diagram FIG. 1, device 10 may include components located on or within an electronic device housing such as housing 12. Housing 12, which may sometimes be referred to as a case, may be formed of plastic, glass, ceramics, fiber composites, metal (e.g., stainless steel, aluminum, metal alloys, etc.), other suitable materials, or a combination of these materials. In some situations, parts or all of housing 12 may be formed from dielectric or other low-conductivity material (e.g., glass, ceramic, plastic, sapphire, etc.). In other situations, housing 12 or at least some of the structures that make up housing 12 may be formed from metal elements.

Device 10 may include control circuitry 14. Control circuitry 14 may include storage such as storage circuitry 16. Storage circuitry 16 may include hard disk drive storage, nonvolatile memory (e.g., flash memory or other electrically-programmable-read-only memory configured to form a solid-state drive), volatile memory (e.g., static or dynamic random-access-memory), etc. Storage circuitry 16 may include storage that is integrated within device 10 and/or removable storage media.

Control circuitry 14 may include processing circuitry such as processing circuitry 18. Processing circuitry 18 may be used to control the operation of device 10. Processing circuitry 18 may include on one or more microprocessors, microcontrollers, digital signal processors, host processors, baseband processor integrated circuits, application processor, application specific integrated circuits, central processing units (CPUs), etc. Control circuitry 14 may be configured to perform operations in device 10 using hardware (e.g., dedicated hardware or circuitry), firmware, and/or software. Software code for performing operations in device 10 may be stored on storage circuitry 16 (e.g., storage circuitry 16 may include non-transitory (tangible) computer readable storage media that stores the software code). The software code may sometimes be referred to as program instructions, software, data, instructions, or code. Software code stored on storage circuitry 16 may be executed by processing circuitry 18.

Control circuitry 14 may be used to run software on device 10 such as satellite navigation applications, internet browsing applications, voice-over-internet-protocol (VOIP) telephone call applications, email applications, media playback applications, operating system functions, etc. To support interactions with external equipment, control circuitry 14 may be used in implementing communications protocols. Communications protocols that may be implemented using control circuitry 14 include internet protocols, wireless local area network (WLAN) protocols (e.g., IEEE 802.11 protocols - sometimes referred to as Wi-Fi®), protocols for other short-range wireless communications links such as the Bluetooth® protocol or other wireless personal area network (WPAN) protocols, IEEE 802.11ad protocols (e.g., ultra-wideband protocols), cellular telephone protocols (e.g., 3G protocols, 4G (LTE) protocols, 5G New Radio (NR) protocols, etc.), MIMO protocols, antenna diversity protocols, satellite navigation system protocols (e.g., global positioning system (GPS) protocols, global navigation satellite system (GLONASS) protocols, etc.), antenna-based spatial ranging protocols (e.g., radio detection and ranging (RADAR) protocols or other desired range detection protocols for signals conveyed at millimeter and centimeter wave frequencies), or any other desired communications protocols. Each communications protocol may be associated with a corresponding radio access technology (RAT) that specifies the physical connection methodology used in implementing the protocol.

Device 10 may include input-output circuitry 20. Input-output circuitry 20 may include input-output devices 22. Input-output devices 22 may be used to allow data to be supplied to device 10 and to allow data to be provided from device 10 to external devices. Input-output devices 22 may include user interface devices, data port devices, and other input-output components. For example, input-output devices 22 may include touch sensors, displays, light-emitting components such as displays without touch sensor capabilities, buttons (mechanical, capacitive, optical, etc.), scrolling wheels, touch pads, key pads, keyboards, microphones, cameras, buttons, speakers, status indicators, audio jacks and other audio port components, digital data port devices, motion sensors (accelerometers, gyroscopes, and/or compasses that detect motion), capacitance sensors, proximity sensors, magnetic sensors, force sensors (e.g., force sensors coupled to a display to detect pressure applied to the display), etc. In some configurations, keyboards, headphones, displays, pointing devices such as trackpads, mice, electronic pencil (e.g., a stylus), and joysticks, and other input-output devices may be coupled to device 10 using wired or wireless connections (e.g., some of input-output devices 22 may be peripherals that are coupled to a main processing unit or other portion of device 10 via a wired or wireless link).

Input-output circuitry 24 may include wireless communications circuitry such as wireless communications circuitry 34 (sometimes referred to herein as wireless circuitry 24) for wirelessly conveying radio-frequency signals. While control circuitry 14 is shown separately from wireless communications circuitry 24 for the sake of clarity, wireless communications circuitry 24 may include processing circuitry that forms a part of processing circuitry 18 and/or storage circuitry that forms a part of storage circuitry 16 of control circuitry 14 (e.g., portions of control circuitry 14 may be implemented on wireless communications circuitry 24). As an example, control circuitry 14 (e.g., processing circuitry 18) may include baseband processor circuitry or other control components that form a part of wireless communications circuitry 24.

Wireless communications circuitry 24 may include radio-frequency (RF) transceiver circuitry formed from one or more integrated circuits, power amplifier circuitry configured to amplify uplink radio-frequency signals (e.g., radio-frequency signals transmitted by device 10 to an external device), low-noise amplifiers configured to amplify downlink radio-frequency signals (e.g., radio-frequency signals received by device 10 from an external device), passive radio-frequency components, one or more antennas, transmission lines, and other circuitry for handling radio-frequency wireless signals. Wireless signals can also be sent using light (e.g., using infrared communications).

Wireless circuitry 24 may include radio-frequency transceiver circuitry for handling transmission and/or reception of radio-frequency signals in various radio-frequency communications bands. For example, the radio-frequency transceiver circuitry may handle wireless local area network (WLAN) communications bands such as the 2.4 GHz and 5 GHz Wi-Fi® (IEEE 802.11) bands, wireless personal area network (WPAN) communications bands such as the 2.4 GHz Bluetooth® communications band, cellular telephone communications bands such as a cellular low band (LB) (e.g., 600 to 960 MHz), a cellular low-midband (LMB) (e.g., 1400 to 1550 MHz), a cellular midband (MB) (e.g., from 1700 to 2200 MHz), a cellular high band (HB) (e.g., from 2300 to 2700 MHz), a cellular ultra-high band (UHB) (e.g., from 3300 to 5000 MHz), or other cellular communications bands between about 600 MHz and about 5000 MHz (e.g., 3G bands, 4G LTE bands, 5G New Radio Frequency Range 1 (FR1) bands below 10 GHz, 5G New Radio Frequency Range 2 (FR2) bands at millimeter and centimeter wavelengths between 20 and 60 GHz, etc.), a near-field communications (NFC) band (e.g., at 13.56 MHz), satellite navigations bands (e.g., an L1 global positioning system (GPS) band at 1575 MHz, an L5 GPS band at 1176 MHz, a Global Navigation Satellite System (GLONASS) band, a BeiDou Navigation Satellite System (BDS) band, etc.), an ultra-wideband (UWB) communications band supported by the IEEE 802.15.4 protocol and/or other UWB communications protocols (e.g., a first UWB communications band at 6.5 GHz and/or a second UWB communications band at 8.0 GHz), and/or any other desired communications bands. The communications bands handled by such radio-frequency transceiver circuitry may sometimes be referred to herein as frequency bands or simply as "bands," and may span corresponding ranges of frequencies. In general, the radio-frequency transceiver circuitry within wireless circuitry 24 may cover (handle) any desired frequency bands of interest.

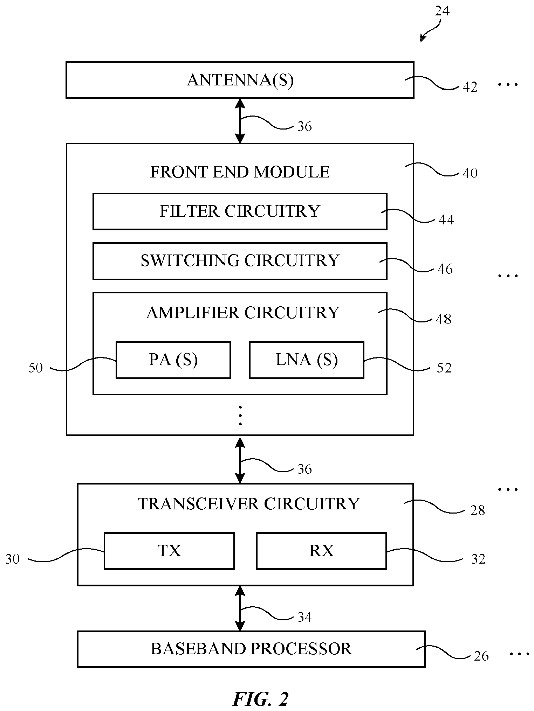

FIG. 2 is a diagram showing illustrative components within wireless circuitry 24. As shown in FIG. 2, wireless circuitry 24 may include a baseband processor such as baseband processor 26, radio-frequency (RF) transceiver circuitry such as radio-frequency transceiver 28, radio-frequency front end circuitry such as radio-frequency front end module (FEM) 40, and antenna(s) 42. Baseband processor 26 may be coupled to transceiver 28 over baseband path 34. Transceiver 28 may be coupled to antenna 42 via radio-frequency transmission line path 36. Radio-frequency front end module 40 may be disposed on radio-frequency transmission line path 36 between transceiver 28 and antenna 42.

In the example of FIG. 2, wireless circuitry 24 is illustrated as including only a single baseband processor 26, a single transceiver 28, a single front end module 40, and a single antenna 42 for the sake of clarity. In general, wireless circuitry 24 may include any desired number of baseband processors 26, any desired number of transceivers 36, any desired number of front end modules 40, and any desired number of antennas 42. Each baseband processor 26 may be coupled to one or more transceiver 28 over respective baseband paths 34. Each transceiver 28 may include a transmitter circuit 30 configured to output uplink signals to antenna 42, may include a receiver circuit 32 configured to receive downlink signals from antenna 42, and may be coupled to one or more antennas 42 over respective radio-frequency transmission line paths 36. Each radio-frequency transmission line path 36 may have a respective front end module 40 disposed thereon. If desired, two or more front end modules 40 may be disposed on the same radio-frequency transmission line path 36. If desired, one or more of the radio-frequency transmission line paths 36 in wireless circuitry 24 may be implemented without any front end module disposed thereon.

Radio-frequency transmission line path 36 may be coupled to an antenna feed on antenna 42. The antenna feed may, for example, include a positive antenna feed terminal and a ground antenna feed terminal. Radio-frequency transmission line path 36 may have a positive transmission line signal path such that is coupled to the positive antenna feed terminal on antenna 42. Radio-frequency transmission line path 36 may have a ground transmission line signal path that is coupled to the ground antenna feed terminal on antenna 42. This example is merely illustrative and, in general, antennas 42 may be fed using any desired antenna feeding scheme. If desired, antenna 42 may have multiple antenna feeds that are coupled to one or more radio-frequency transmission line paths 36.

Radio-frequency transmission line path 36 may include transmission lines that are used to route radio-frequency antenna signals within device 10 (FIG. 1). Transmission lines in device 10 may include coaxial cables, microstrip transmission lines, stripline transmission lines, edge-coupled microstrip transmission lines, edge-coupled stripline transmission lines, transmission lines formed from combinations of transmission lines of these types, etc. Transmission lines in device 10 such as transmission lines in radio-frequency transmission line path 36 may be integrated into rigid and/or flexible printed circuit boards. In one embodiment, radio-frequency transmission line paths such as radio-frequency transmission line path 36 may also include transmission line conductors integrated within multilayer laminated structures (e.g., layers of a conductive material such as copper and a dielectric material such as a resin that are laminated together without intervening adhesive). The multilayer laminated structures may, if desired, be folded or bent in multiple dimensions (e.g., two or three dimensions) and may maintain a bent or folded shape after bending (e.g., the multilayer laminated structures may be folded into a particular three-dimensional shape to route around other device components and may be rigid enough to hold its shape after folding without being held in place by stiffeners or other structures). All of the multiple layers of the laminated structures may be batch laminated together (e.g., in a single pressing process) without adhesive (e.g., as opposed to performing multiple pressing processes to laminate multiple layers together with adhesive).

In performing wireless transmission, baseband processor 26 may provide baseband signals to transceiver 28 over baseband path 34. Transceiver 28 may further include circuitry for converting the baseband signals received from baseband processor 26 into corresponding radio-frequency signals. For example, transceiver circuitry 28 may include mixer circuitry for up-converting (or modulating) the baseband signals to radio-frequencies prior to transmission over antenna 42. The example of FIG. 2 in which baseband processor 26 communicates with transceiver 28 is merely illustrative. In general, transceiver 28 may communicate with a baseband processor, an application processor, a microcontroller, a microprocessor, or one or more processors within circuitry 18. Transceiver circuitry 28 may also include digital-to-analog converter (DAC) and/or analog-to-digital converter (ADC) circuitry for converting signals between digital and analog domains. Transceiver 28 may use transmitter 30 to transmit the radio-frequency signals over antenna 42 via radio-frequency transmission line path 36 and front end module 40. Antenna 42 may transmit the radio-frequency signals to external wireless equipment by radiating the radio-frequency signals into free space.

In performing wireless reception, antenna 42 may receive radio-frequency signals from the external wireless equipment. The received radio-frequency signals may be conveyed to transceiver 28 via radio-frequency transmission line path 36 and front end module 40. Transceiver 28 may include circuitry for converting the received radio-frequency signals into corresponding baseband signals. For example, transceiver 28 may include mixer circuitry for down-converting (or demodulating) the received radio-frequency signals to baseband frequencies prior to conveying the received signals to baseband processor 26 over baseband path 34.

Front end module (FEM) 40 may include radio-frequency front end circuitry that operates on the radio-frequency signals conveyed (transmitted and/or received) over radio-frequency transmission line path 36. FEM 40 may, for example, include front end module (FEM) components such as radio-frequency filter circuitry 44 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), radio-frequency amplifier circuitry 48 (e.g., one or more power amplifier circuits 50 and/or one or more low-noise amplifier circuits 52), impedance matching circuitry (e.g., circuitry that helps to match the impedance of antenna 42 to the impedance of radio-frequency transmission line 36), antenna tuning circuitry (e.g., networks of capacitors, resistors, inductors, and/or switches that adjust the frequency response of antenna 42), radio-frequency coupler circuitry, charge pump circuitry, power management circuitry, digital control and interface circuitry, and/or any other desired circuitry that operates on the radio-frequency signals transmitted and/or received by antenna 42. Each of the front end module components may be mounted to a common (shared) substrate such as a rigid printed circuit board substrate or flexible printed circuit substrate. If desired, the various front end module components may also be integrated into a single integrated circuit chip.

Filter circuitry 44, switching circuitry 46, amplifier circuitry 48, and other circuitry may be disposed along radio-frequency transmission line path 36, may be incorporated into FEM 40, and/or may be incorporated into antenna 42 (e.g., to support antenna tuning, to support operation in desired frequency bands, etc.). These components, sometimes referred to herein as antenna tuning components, may be adjusted (e.g., using control circuitry 14) to adjust the frequency response and wireless performance of antenna 42 over time.

Transceiver 28 may be separate from front end module 40. For example, transceiver 28 may be formed on another substrate such as the main logic board of device 10, a rigid printed circuit board, or flexible printed circuit that is not a part of front end module 40. While control circuitry 14 is shown separately from wireless circuitry 24 in the example of FIG. 1 for the sake of clarity, wireless circuitry 24 may include processing circuitry that forms a part of processing circuitry 18 and/or storage circuitry that forms a part of storage circuitry 16 of control circuitry 14 (e.g., portions of control circuitry 14 may be implemented on wireless circuitry 24). As an example, baseband processor 26 and/or portions of transceiver 28 (e.g., a host processor on transceiver 28) may form a part of control circuitry 14. Control circuitry 14 (e.g., portions of control circuitry 14 formed on baseband processor 26, portions of control circuitry 14 formed on transceiver 28, and/or portions of control circuitry 14 that are separate from wireless circuitry 24) may provide control signals (e.g., over one or more control paths in device 10) that control the operation of front end module 40.

Transceiver circuitry 28 may include wireless local area network transceiver circuitry that handles WLAN communications bands (e.g., Wi-Fi® (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi® 6E band (e.g., from 5925-7125 MHz), and/or other Wi-Fi® bands (e.g., from 1875-5160 MHz), wireless personal area network transceiver circuitry that handles the 2.4 GHz Bluetooth® band or other WPAN communications bands, cellular telephone transceiver circuitry that handles cellular telephone bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, etc.), near-field communications (NFC) transceiver circuitry that handles near-field communications bands (e.g., at 13.56 MHz), satellite navigation receiver circuitry that handles satellite navigation bands (e.g., a GPS band from 1565 to 1610 MHz, a Global Navigation Satellite System (GLONASS) band, a BeiDou Navigation Satellite System (BDS) band, etc.), ultra-wideband (UWB) transceiver circuitry that handles communications using the IEEE 802.15.4 protocol and/or other ultra-wideband communications protocols, and/or any other desired radio-frequency transceiver circuitry for covering any other desired communications bands of interest.

Wireless circuitry 24 may include one or more antennas such as antenna 42. Antenna 42 may be formed using any desired antenna structures. For example, antenna 42 may be an antenna with a resonating element that is formed from loop antenna structures, patch antenna structures, inverted-F antenna structures, slot antenna structures, planar inverted-F antenna structures, helical antenna structures, monopole antennas, dipoles, hybrids of these designs, etc. Two or more antennas 42 may be arranged into one or more phased antenna arrays (e.g., for conveying radio-frequency signals at millimeter wave frequencies). Parasitic elements may be included in antenna 42 to adjust antenna performance. Antenna 42 may be provided with a conductive cavity that backs the antenna resonating element of antenna 42 (e.g., antenna 42 may be a cavity-backed antenna such as a cavity-backed slot antenna).

As described above, front end module 40 may include one or more low noise amplifier (LNA) circuits 52 in the receive (downlink) path. A low noise amplifier 52 (sometimes referred to as low noise amplifier circuitry or amplifier circuitry) may be configured to amplify a received radio-frequency signal without significantly degrading the signal-to-noise (SNR) ratio of the amplified signal. Low noise amplifier 52 may, for example, be used to provide 2 dB of voltage gain, 3 dB of voltage gain, 4 dB of voltage gain, 5 dB of voltage gain, 6 dB of voltage gain, 3-4 dB of voltage gain, 2-5 dB of voltage gain, 5-10 dB of voltage gain, or other suitable amounts of voltage gain.

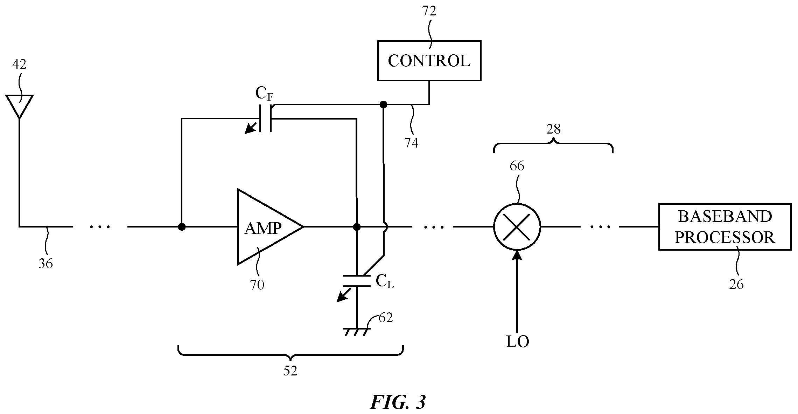

FIG. 3 is a diagram of illustrative low noise amplifier circuitry 52 in the receive path. As shown in FIG. 3, low noise amplifier circuitry 52 may include an amplifier such as amplifier 50 having an input coupled to one or more antennas 42 via radio-frequency transmission line path 36 and an output coupled to a mixer circuit such as mixer 66. As described above in connection with FIG. 3, one or more additional front end module components such as radio-frequency filter circuitry 44 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), impedance matching circuitry, antenna tuning circuitry (e.g., networks of capacitors, resistors, inductors, and/or switches that adjust the frequency response of antenna 42), radio-frequency coupler circuitry, charge pump circuitry, power management circuitry, digital control and interface circuitry, and/or any other desired front-end module circuitry can optionally be coupled between antenna 42 and the input of amplifier 70 along radio-frequency transmission line path 36.

Mixer 66 may sometimes be considered part of transceiver circuitry 28. Mixer 66 may receive signals from low noise amplifier circuitry 52 and may receive a local oscillator signal LO. Mixer 66 may use local oscillator signal LO to down-convert (or demodulate) the radio-frequency signals to baseband frequencies and then outputting the corresponding baseband signals to baseband processor 26. Baseband processor 26 may sometimes be considered part of wireless communications circuitry 24 or part of processing circuitry 18 in control circuitry 14. The output of low noise amplifier circuitry 52 may or may not be directly coupled to mixer 66. In some embodiments, one or more additional radio-frequency amplifiers may be interposed between the output of LNA circuitry 52 and the input of mixer 66.

A conventional low noise amplifier might include multiple amplifier units (slices) coupled together in parallel and an adjustable feedback resistor coupled across the multiple amplifier units. To change the gain setting of such low noise amplifier, a number of the multiple amplifier units may be activated or deactivated. For instance, in a high gain mode, a larger number of amplifier units may be enabled to increase the overall gain of the low noise amplifier. In a low gain mode, a smaller number of the amplifier units may be enabled to reduce the overall gain of the low noise amplifier. The feedback resistor may be adjusted to provide the desired input resistance for the low noise amplifier at the different gain modes. In the low gain mode, however, the feedback resistor and the overall current of the low noise amplifier have to be small to maintain the desired input resistance, which degrades the noise figure of the low noise amplifier. It would therefore be desirable to provide improved low noise amplifier circuitry with an adjustable gain while being able to maintain input impedance matching at different gain settings without adversely impacting the overall noise figure.

In accordance with an embodiment, LNA circuitry 52 may further include an adjustable load capacitive circuit such as adjustable load capacitance $C_L$ shunted at the output of amplifier 70 and an adjustable feedback capacitive circuit such as adjustable feedback capacitance $C_F$ coupled across the input and output of amplifier 70. In particular, adjustable load capacitance $C_L$ has a first terminal coupled to the output of amplifier 70 and a second terminal coupled to a ground power supply line 62 (sometimes referred to as a ground line or ground terminal). Adjustable feedback capacitance $C_F$ has a first output terminal to the output of amplifier 70 and a second terminal coupled to the input of amplifier 70.

Adjustable capacitances $C_L$ and $C_F$ can be tuned using an amplifier control circuit such as amplifier controller 72. Capacitance $C_L$ is generally much larger than capacitance $C_F$ so that the output impedance of amplifier circuitry 52 is dominated by $C_L$. Controller 72 may have an output coupled to capacitance $C_L$ and capacitance $C_F$ via path 74. Controller 72 may output control signals on path 74 for separately adjusting capacitance $C_L$ and capacitance $C_F$. Controller 72 may sometimes be considered part of baseband processor 26, transceiver circuitry 28, or part of one or more processors in control circuitry 14 (see FIG. 1). Controller 72 may be used to simultaneously adjust the gain and the input impedance of amplifier circuitry 52. Configured using the capacitive load and feedback network as shown in FIG. 3, the gain of amplifier circuitry 52, assuming $C_L$ is much larger than $C_F$, may be expressed as follows:

$$Gain \approx \frac{g_m}{C_L * \omega_{LO}}$$

$$(1)$$

As shown by equation 1, the gain of the amplifier circuitry 52 is directly proportional to the transconductance of amplifier 70 (sometimes abbreviated as $g_m$) and is inversely proportional to the product of the load capacitance $C_L$ and the frequency of the local oscillator signal, where $\omega_{LO}$ is equal to $2\pi$ times the frequency of the local oscillator signal. Transconductance is a measure of the output current of a device relative to its input voltage. Thus, transconductance can represents the amount of current being consumed by a particular device. Here, the forward current conveyed through capacitance $C_F$ is assumed to be relatively small, so the overall gain can be approximately defined by the transconductance of amplifier 70.

To adjust the gain of amplifier circuitry 52, control circuit 72 can simply adjust load capacitance $C_L$. For example, control circuit 72 may send gain control bits to double the value of load capacitance $C_L$, which effectively reduces the gain of amplifier circuitry 52 by half. As another example, control circuit 72 may send gain control bits to quadruple the value of load capacitance $C_L$, which effectively reduces the gain of amplifier circuitry 52 to a quarter of its previous gain setting. As yet another example, control circuit 72 may send gain control bits to halve the value of load capacitance $C_L$, which effectively doubles the gain of amplifier circuitry 52.

It is also important to provide proper input impedance matching for amplifier circuitry 52 at the various gain levels. In the frequency ranges of interest and assuming the output impedance of amplifier 70 is dominated by load capacitance $C_L$, the real value of the input impedance or the input resistance of amplifier 70 can be expressed as follows:

$$Rin_{real} \approx \frac{1}{g_m} * \frac{C_F + C_L}{C_F}$$

$$(2)$$

As shown by equation 2, the input resistance of amplifier 70 (i.e., $Rin_{real}$) may be a function of the reciprocal of amplifier transconductance $g_m$ multiplied by the sum of value of capacitances $C_F$ and $C_L$ divided by the value of $C_F$. As described above in connection with equation 1, control circuit 72 can send gain control bits to $C_L$ to adjust the gain of amplifier circuitry 52. Thus, in order to maintain the value of the input resistance, the value of capacitance $C_F$ needs to be updated in conjunction with capacitance $C_L$. In other words, the input resistance can be maintained as long as the ratio of $C_L$ to $C_F$ is kept relatively constant at different gain settings. Control circuit 72 can send control bits to update the value of capacitance $C_F$ to keep the load to feedback capacitive ratio constant to maintain the input resistance of amplifier circuity 52 at some target value. Control circuit 72 is therefore sometimes referred to as a gain and impedance matching control circuit.

As an example, amplifier 70 may be a transconductance amplifier. As shown by equation 1, the gain of amplifier circuity 52 can be adjusted by controlling $C_L$ without changing the transconductance of amplifier 70. As shown by equation 2, the input resistance of amplifier circuitry 52 can be sustained by maintaining the ratio of $C_L$ to $C_F$ again without changing the transconductance of amplifier 70. In other words, the gain of amplifier circuitry 52 can be adjusted while maintaining its input resistance without having to change the current consumption of amplifier 70. Configured and operated in this way, amplifier circuitry 52 can provide adjustable gain control with minimal impact to the overall noise figure.

This example in which amplifier 70 is described as a transconductance amplifier is merely illustrative. In general, any type of amplifier having an output impedance that is substantially larger than the impedance of capacitance $C_L$ at the operating frequency of interest can be used within low noise amplifier circuitry 52. In other words, amplifier 70 should have an output impedance that is at least two times greater than the impedance of $C_L$, at least three times greater than the impedance of $C_L$, at least four times greater than the impedance of $C_L$, four to ten times greater than the impedance of $C_L$, at least ten times greater than the impedance of $C_L$, 10-20 times greater than the impedance of $C_L$, 20-50 times greater than the impedance of $C_L$, 50-100 times greater than the impedance of $C_L$, or more than 100 times greater than the impedance of $C_L$. Device configurations in which circuitry 52 includes a transconductance amplifier 70 may sometimes be described as an example herein.

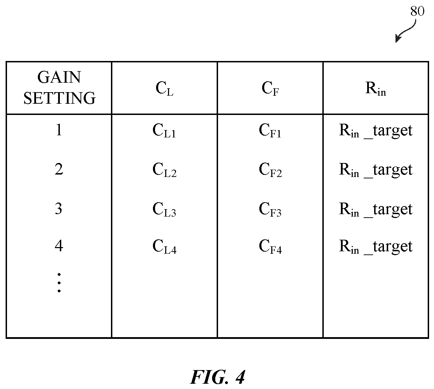

FIG. 4 is a table 80 showing illustrative capacitance values corresponding to different amplifier gain settings. Gain setting of "1" may corresponding to a low gain setting (mode), where the load capacitance is set to a high capacitance value of $C_{L1}$ and where the feedback capacitance is set to a value of $C_{F1}$. To ensure that the input resistance Rin is equal to a target resistance level Rin target, the ratio of $C_{L1}$ to $C_{F1}$ may be set to some predetermined value. As an example, the target resistance level may be equal to 50 $\Omega$. This is, however, merely illustrative. In other suitable embodiments, the target resistance level may be equal to 60 Ω, 70 Ω, 80 Ω, 50-90 Ω, less than 50 Ω, greater than 50 Ω, less than 70 Ω, greater than 70 Ω, hundreds of ohms, or other resistance level. The ratio of $C_{L1}$ to $C_{F1}$ may, for example, be equal to 6:1. This predetermined ratio is also merely illustrative. In other embodiments, the ratio of $C_{L1}$ to $C_{F1}$ may be set equal to 3:1, 4:1, 5:1, 5.5:1, 6.1:1, 6.5:1, 7:1, 8:1, 9:1, or generally $m$:1, where $m$ can be any suitable integer or decimal number. Thus, when the load and feedback components are the same type of electrical components (e.g., when both the load and feedback components are adjustable capacitances), then controller 72 may be configured to maintain the ratio of the two components.

A gain setting of "2" may corresponding to a relatively higher gain setting, where the load capacitance is set to a smaller capacitance value of $C_{L2}$ (e.g., $C_{L2}$ is smaller than $C_{L1}$) and where the feedback capacitance is set to a value of $C_{F2}$. To ensure that the input resistance Rin is maintained at the target resistance level Rin target, the ratio of $C_{L2}$ to $C_{F2}$ may be sustained at the predetermined value of 6:1 (as an example) by likewise reducing the value of the feedback capacitance. The values of the load and feedback capacitances are therefore generally adjusted in the same direction.

A gain setting of "3" may corresponding to an ever higher gain setting, where the load capacitance is set to an even smaller capacitance value of $C_{L3}$ (e.g., $C_{L3}$ is smaller than $C_{L2}$) and where the feedback capacitance is set to a value of $C_{F3}$. To ensure that the input resistance Rin is maintained at the target resistance level Rin target, the ratio of $C_{L3}$ to $C_{F3}$ may be sustained at the predetermined value of 6:1 (as an example) by likewise reducing the value of the feedback capacitance. The values of the load and feedback capacitances are again adjusted in the same direction.

A gain setting of "4" may corresponding to a high gain setting (mode), where the load capacitance is set to a small capacitance value of $C_{L4}$ (e.g., $C_{L4}$ is smaller than $C_{L3}$) and where the feedback capacitance is set to a value of $C_{F4}$. To ensure that the input resistance Rin is maintained at the target resistance level Rin target, the ratio of $C_{L4}$ to $C_{F4}$ may be sustained at the predetermined value of 6:1 (as an example) by likewise reducing the value of the feedback capacitance. The values of the load and feedback capacitances are again adjusted in the same direction. The example of FIG. 4 showing four possible gain settings (modes) is merely illustrative and is not intended to limit the scope of the present embodiments. If desired, low noise amplifier circuitry 52 may be operable in more than four gain modes, 4-10 different gain modes, more than 10 different gain modes, 10-20 gain modes, more than 20 gain modes, fewer than four gain modes, etc.

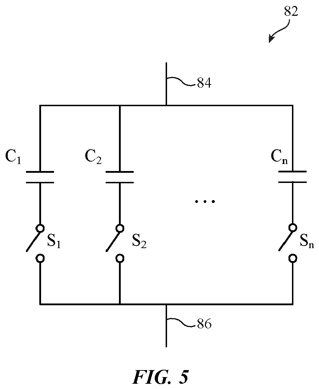

To support the different gain modes, the load capacitance $C_L$ and the feedback capacitance $C_F$ may be implemented as adjustable capacitor (or capacitive) circuits. FIG. 5 is a circuit diagram of an illustrative adjustable capacitive circuit 82. As shown in FIG. 5, circuit 82 may include a first terminal 84, a second terminal 86, and a plurality of capacitors $C_1$-$C_n$ switchably coupled between terminals 84 and 86. For instance, capacitor $C_1$ may be coupled in series with switch $S_1$ between terminals 84 and 86; capacitor $C_2$ may be coupled in series with switch $S_2$ between terminals 84 and 86; ...; and capacitor $C_n$ may be coupled in series with switch $S_n$ between terminals 84 and 86. The number of switchable capacitor strings (branches) n within circuit 82 may be equal to 2, 3, 4, 2-8, 8-16, 16-32, 32-64, or other integer values. The state of switches $S_1$-$S_n$ may be controlled by control circuit 72. Gain and impedance matching control circuit 72 may output control signals to selectively activate and deactivate different groups of switches so that circuit 82 can provide the requisite capacitance value that would yield the desired gain and/or input impedance (resistance) for amplifier circuitry 52.

The example of FIG. 5 in which the load capacitance and/or the feedback capacitance can be implemented as an array or bank of switchable capacitors is merely illustrative. Such type of capacitive bank may provide discrete capacitance values with good linearity, especially when the size of the switches $S_1$-$S_n$ are relatively large. In other embodiments, the load capacitance and/or the feedback capacitance may be implemented as a metal-oxide-semiconductor capacitor (MOSCAP), which can provide a non-linear capacitance. In yet other embodiments, the load capacitance and/or the feedback capacitance may be implemented as a varactor or a variable capacitor, which can provide continuous capacitance values for improved tuning capabilities (e.g., to provide fine gain adjustments).

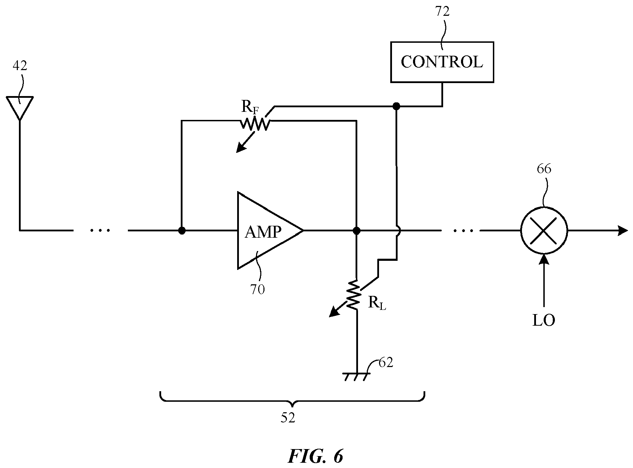

The embodiment of FIG. 3 in which load capacitance $C_L$ and feedback capacitance $C_F$ are implemented as adjustable capacitive circuits is merely illustrative. FIG. 6 illustrates another embodiment of low noise amplifier circuitry 52 having an adjustable resistive network. As shown in FIG. 6, LNA circuitry 52 may include an adjustable load resistive circuit such as adjustable load resistance $R_L$ shunted at the output of amplifier 70 and an adjustable feedback resistive circuit such as adjustable feedback resistance $R_F$ coupled across the input and output of amplifier 70. In particular, adjustable load resistance $R_L$ has a first terminal coupled to the output of amplifier 70 and a second terminal coupled to ground line 62. Adjustable feedback resistance $R_F$ has a first output terminal to the output of amplifier 70 and a second terminal coupled to the input of amplifier 70.

Adjustable resistances $R_L$ and $R_F$ can be tuned using an amplifier control circuit such as amplifier controller 72. Controller 72 may output control signals on path 74 for separately adjusting resistance $R_L$ and resistance $R_F$. Unlike equation 1 where the gain is inversely proportional to capacitance $C_L$, the gain of amplifier circuitry 52 of FIG. 6 may be directly proportional to resistance $R_L$. Thus, controller 72 may increase the value of resistance $R_L$ to boost the gain of amplifier circuitry 52 and may decrease the value of resistance $R_L$ to reduce the gain of amplifier circuitry 52. To maintain the input resistance matching behavior of amplifier circuitry 52 at different gain settings (modes), controller 72 may likewise adjust $R_F$ so that the ratio of $R_F$ to $R_L$ is maintained at some predetermined constant value. The ratio of $R_F$ to $R_L$ may be set equal to 3:1, 4:1, 5:1, 5.5:1, 6:1, 6.1:1, 6.5:1, 7:1, 8:1, 9:1, or generally $m$:1, where $m$ can be any suitable integer or decimal number. Thus, when the load and feedback components are the same type of electrical components (e.g., when both the load and feedback components are adjustable resistances), then controller 72 may be configured to maintain the ratio of the two resistances. Adjustable resistances $R_L$ and $R_F$ can each be implemented as an array or bank of switchable resistors, a variable resistor to provide continuous resistance tuning, or other types of resistive elements.

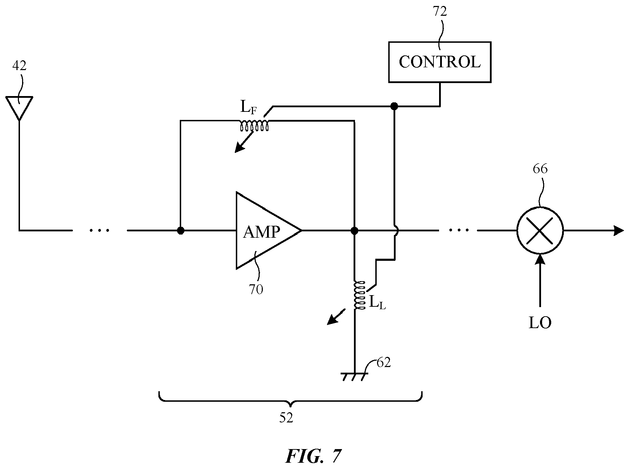

The embodiment of FIG. 6 in which load resistance $R_L$ and feedback resistance $R_F$ are implemented as adjustable resistive circuits is merely illustrative. FIG. 7 illustrates another embodiment of low noise amplifier circuitry 52 having an adjustable inductive network. As shown in FIG. 7, LNA circuitry 52 may include an adjustable load inductive circuit such as adjustable load inductance $L_L$ shunted at the output of amplifier 70 and an adjustable feedback inductive circuit such as adjustable feedback inductance $L_F$ coupled across the input and output of amplifier 70. In particular, adjustable load inductance $L_L$ has a first terminal coupled to the output of amplifier 70 and a second terminal coupled to ground line 62. Adjustable feedback inductance $L_F$ has a first output terminal to the output of amplifier 70 and a second terminal coupled to the input of amplifier 70.

Adjustable inductances $L_L$ and $L_F$ can be tuned using an amplifier control circuit such as amplifier controller 72. Controller 72 may output control signals on path 74 for separately adjusting inductance $L_L$ and inductance $L_F$. Unlike equation 1 where the gain is inversely proportional to capacitance $C_L$, the gain of amplifier circuitry 52 of FIG. 6 may be directly proportional to inductance $L_L$. Thus, controller 72 may increase the value of inductance $L_L$ to boost the gain of amplifier circuitry 52 and may decrease the value of inductance $L_L$ to reduce the gain of amplifier circuitry 52. To maintain the input resistance matching behavior of amplifier circuitry 52 at different gain settings (modes), controller 72 may likewise adjust $L_F$ so that the ratio of $L_F$ to $L_L$ is maintained at some predetermined constant value. The ratio of $L_F$ to $L_L$ may be set equal to 3:1, 4:1, 5:1, 5.5:1, 6:1, 6.1:1, 6.5:1, 7:1, 8:1, 9:1, or generally $m$:1, where $m$ can be any suitable integer or decimal number. Thus, when the load and feedback components are the same type of electrical components (e.g., when both the load and feedback components are adjustable inductances), then controller 72 may be configured to maintain the ratio of the two inductances. Adjustable inductances $L_L$ and $L_F$ can each be implemented as an array or bank of switchable inductors, a variable inductor to provide continuous inductance tuning, or other types of inductive elements.

The embodiments of FIGS. 3, 6, and 7 in which the adjustable load component and the adjustable feedback component are the same type of components is merely illustrative.

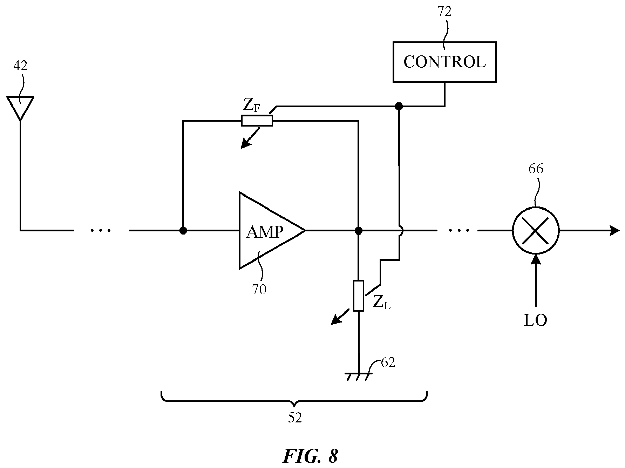

FIG. 8 illustrates another embodiment of low noise amplifier circuitry 52 having an adjustable hybrid impedance network. As shown in FIG. 8, LNA circuitry 52 may include an adjustable load component such as adjustable load component $Z_L$ shunted at the output of amplifier 70 and an adjustable feedback component such as adjustable feedback component $Z_F$ coupled across the input and output of amplifier 70. In particular, adjustable load component $Z_L$ has a first terminal coupled to the output of amplifier 70 and a second terminal coupled to ground line 62. Adjustable feedback component $Z_F$ has a first output terminal to the output of amplifier 70 and a second terminal coupled to the input of amplifier 70.

Adjustable load component $Z_L$ and adjustable feedback component $Z_F$ can be different types of passive components. In one example, load component $Z_L$ can be an adjustable load capacitance while feedback component $Z_F$ can be an adjustable feedback inductance. As another example, load component $Z_L$ can be an adjustable load inductance while feedback component $Z_F$ can be an adjustable feedback capacitance. As described above in connection with FIGS. 3, 6, and 7, when the load and feedback components are the same type of electrical components, then controller 72 may be configured to maintain the ratio of the two component values across different gain modes. However, when the load and feedback components are different types of components such as when the adjustable and load components are adjustable inductances and capacitances or vice versa, controller 72 may be configured to maintain a product of the two component values across different gain modes (e.g., to set the product of the two component values to a predetermined constant value regardless of the gain setting). In these examples, controller 72 can adjust the impedance of load component $Z_L$ to adjust the gain of amplifier circuitry 52 while adjusting the impedance of feedback component $Z_F$ to maintain the input resistance of amplifier circuitry 52 at the target resistance level. If desired, controller 72 may adjust both $Z_L$ and $Z_F$ while ensuring that the ratio of $Z_L$ to $Z_F$ is maintained at some predetermined value greater than one or less than one.

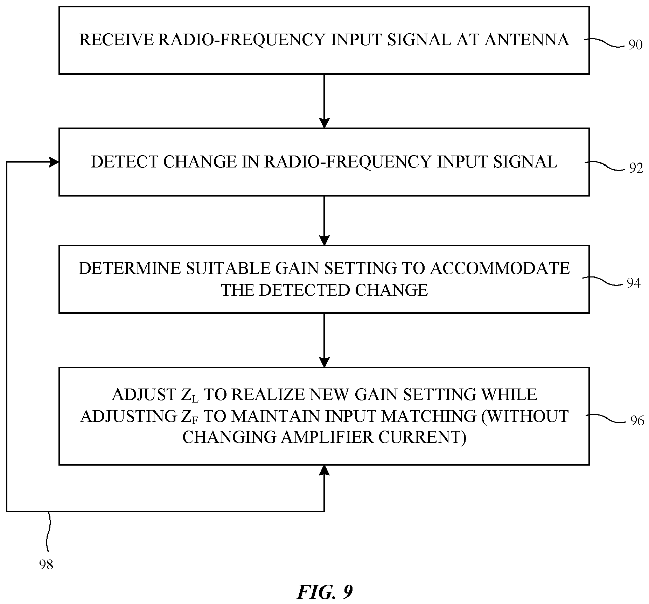

FIG. 9 is a flow chart of illustrative steps for operating low noise amplifier circuitry 52 of the type shown in FIGS. 3, 6, 7, and 8. During the operations of block 90, an antenna such as antenna 42 may receive radio-frequency input signals. The received radio-frequency signals may be passed through front end module 40, demodulated and converted to digital baseband signals using transceiver circuitry 28, and then processed using baseband processor 26 (or other processor within circuitry 18). Front end module 40 may include LNA circuitry 52 for amplifying the radio-frequency signals prior to arriving at transceiver circuitry 28. Amplifier circuitry 52 may be configured with an initial gain setting suitable for amplifying the radio-frequency signals currently being received at antenna 42.

During the operations of block 92, the wireless communications circuitry may detect a change in the radio-frequency signal. For example, the wireless communications circuitry may detect a need to change the gain setting for amplifier circuitry 52. When the power level of the radio-frequency signal decreases, the wireless circuitry may compensate for such decrease in the power level by increasing the gain of amplifier circuitry 52 so that signals received at transceiver 28 has a sufficient signal swing. When the power level of the radio-frequency signal increase, the wireless circuitry may compensate for such increase in the power level be backing off the gain of amplifier circuitry 52 so that signals received at transceiver 28 is not overly clipped.

During the operations of block 94, the wireless communications circuitry may determine a suitable gain setting to accommodate the detected changes. The selected gain mode should provide sufficient signal gain without consuming excessive amounts of power. For example, controller 72 may obtain a new gain code for adjusting the load component and the feedback component to realize the new gain mode.

During the operations of block 96, controller 72 may adjust load component $Z_L$ (e.g., an adjustable capacitance, inductance, resistance, etc.) to achieve the new gain setting while adjusting feedback component $Z_F$ (e.g., an adjustable capacitance, inductance, resistance, etc.) to maintain the input resistance of amplifier circuitry 52 at the target level. Amplifier circuitry 52 can operate in different gain modes without changing the amount of current through amplifier 70 (e.g., without changing the amplifier transconductance $g_m$). Operated in this way, amplifier circuitry 52 can provide coarse or fine gain steps to accommodate different signal input levels while maintaining input impedance matching across the different gain steps with minimal noise penalty.

The operations of FIG. 9 are merely illustrative. At least some of the described operations may be modified or omitted; some of the described operations may be performed in parallel; additional processes may be added or inserted between the described operations; the order of certain operations may be reversed or altered; the timing of the described operations may be adjusted so that they occur at slightly different times, or the described operations may be distributed in a system.

The methods and operations described above in connection with FIGS. 1-7 may be performed by the components of device 10 using software, firmware, and/or hardware (e.g., dedicated circuitry or hardware). Software code for performing these operations may be stored on non-transitory computer readable storage media (e.g., tangible computer readable storage media) stored on one or more of the components of device 10 (e.g., storage circuitry 16 and/or wireless communications circuitry 24 of FIG. 1). The software code may sometimes be referred to as software, data, instructions, program instructions, or code. The non-transitory computer readable storage media may include drives, non-volatile memory such as non-volatile random-access memory (NVRAM), removable flash drives or other removable media, other types of random-access memory, etc. Software stored on the non-transitory computer readable storage media may be executed by processing circuitry on one or more of the components of device 10 (e.g., processing circuitry in wireless circuitry 24, processing circuitry 18 of FIG. 1, etc.). The processing circuitry may include microprocessors, application processors, digital signal processors, central processing units (CPUs), application-specific integrated circuits with processing circuitry, or other processing circuitry.

According to a first aspect of the invention, amplifier circuitry is provided that includes an amplifier having an input coupled to an antenna and having an output, an adjustable load component having a first terminal coupled to the output of the amplifier and having a second terminal coupled to a ground power supply line, an adjustable feedback component having a first terminal coupled to the output of the amplifier and having a second terminal coupled to the input of the amplifier and a gain and impedance matching control circuit having an output coupled to the adjustable load component and the adjustable feedback component.

Preferably, the adjustable load component includes an adjustable load capacitance coupled between the output of the amplifier and the ground power supply line and the adjustable feedback component includes an adjustable feedback capacitance coupled between the output and the input of the amplifier.

Preferably, the adjustable load component includes an adjustable load inductance coupled between the output of the amplifier and the ground power supply line and the adjustable feedback component includes an adjustable feedback inductance coupled between the output and the input of the amplifier.

Preferably, the adjustable load component includes an adjustable load resistance coupled between the output of the amplifier and the ground power supply line and the adjustable feedback component includes an adjustable feedback resistance coupled between the output and the input of the amplifier.

Preferably, the adjustable load component includes an adjustable load capacitance coupled between the output of the amplifier and the ground power supply line and the adjustable feedback component includes an adjustable feedback inductance coupled between the output and the input of the amplifier.

Preferably, the adjustable load component includes an adjustable load inductance coupled between the output of the amplifier and the ground power supply line and the adjustable feedback component includes an adjustable feedback capacitance coupled between the output and the input of the amplifier.

Preferably, the gain and impedance matching control circuit is configured to control a gain of the amplifier circuitry by adjusting the adjustable load component and maintain an input resistance of the amplifier circuitry at a target level by adjusting the adjustable feedback component.

Preferably, the gain and impedance matching control circuit is configured to generate control signals at its output for adjusting a gain of the amplifier circuitry without changing an amount of current flowing through the amplifier.

Preferably, the adjustable load component and the adjustable feedback component are the same type of components and the gain and impedance matching control circuit is configured to set a ratio of a value of the adjustable load component to a value of the adjustable feedback component to a predetermined constant when the amplifier circuitry is operated at a first gain mode and set the ratio to the predetermined constant when the amplifier circuitry is operated at a second gain mode different than the first gain mode.

Preferably, the adjustable load component and the adjustable feedback component are different types of components and the gain and impedance matching control circuit is configured to set a product of a value of the adjustable load component and a value of the adjustable feedback component to a predetermined constant when the amplifier circuitry is operated at a first gain mode and set the product to the predetermined constant when the amplifier circuitry is operated at a second gain mode different than the first gain mode.

Preferably, the amplifier has an output impedance that is at least two times greater than an impedance of the adjustable load component.

Preferably, the amplifier includes a transconductance amplifier having an output impedance that is at least five times greater than the impedance of the adjustable load component.

According to a second aspect of the invention, a method of operating amplifier circuitry is provided, the method includes receiving at an input of an amplifier a radio-frequency signal, outputting at an output of the amplifier an amplified signal to a mixer and adjusting an adjustable load component coupled to the output of the amplifier to tune a gain of the amplifier circuitry while adjusting an adjustable feedback component coupled across the output and the input of the amplifier to set an input resistance of the amplifier circuitry.

Preferably, the method includes tuning the gain of the amplifier circuitry without changing a transconductance of the amplifier.

Preferably, the adjustable load component and the adjustable feedback component are the same type of adjustable electrical components.

Preferably, the method includes setting a ratio of a value of the adjustable load component to a value of the adjustable feedback component to a predetermined constant when the amplifier circuitry is operated in a first gain mode, setting the ratio to the predetermined constant when the amplifier circuitry is operated in a second gain mode different than the first gain mode and setting the ratio to the predetermined constant when the amplifier circuitry is operated in a third gain mode different than the first and second gain modes.

Preferably, the adjustable load component and the adjustable feedback component are different types of adjustable electrical components.

Preferably, the method includes setting a product of a value of the adjustable load component and a value of the adjustable feedback component to a predetermined constant when the amplifier circuitry is operated in a first gain mode, setting the product to the predetermined constant when the amplifier circuitry is operated in a second gain mode different than the first gain mode and setting the product to the predetermined constant when the amplifier circuitry is operated in a third gain mode different than the first and second gain modes.

According to a third aspect of the invention, an electronic device is provided that includes an antenna configured to receive radio-frequency signals, a transceiver configured to generate baseband signals based on the radio-frequency signals, one or more processors configured to receive the baseband signals and amplifier circuitry configured to receive the radio-frequency signals from the antenna and to output corresponding amplified signals to the transceiver, the amplifier circuitry including an amplifier having an input and an output with an output impedance, an adjustable load capacitance having a first terminal coupled to the output of the amplifier and having a second terminal coupled to a ground line, the adjustable load capacitance having a load impedance that is smaller than the output impedance of the amplifier, an adjustable feedback capacitance having a first terminal coupled to the output of the amplifier and having a second terminal coupled to the input of the amplifier, and a gain and impedance matching control circuit coupled to the adjustable load capacitance and the adjustable feedback capacitance.

Preferably, the gain and impedance matching control circuit is configured to set a ratio of a value of the adjustable load capacitance to a value of the adjustable feedback capacitance to a predetermined constant when the amplifier circuitry is operated at a first gain mode and set the ratio to the predetermined constant when the amplifier circuitry is operated at a second gain mode different than the first gain mode.

The foregoing is merely illustrative and various modifications can be made to the described embodiments. The foregoing embodiments may be implemented individually or in any combination.

**Claims**

1. Amplifier circuitry comprising:

   an amplifier having an input coupled to an antenna and having an output;
   an adjustable load component having a first terminal coupled to the output of the amplifier and having a second terminal coupled to a ground power supply line;
   an adjustable feedback component having a first terminal coupled to the output of the amplifier and having a second terminal coupled to the input of the amplifier; and
   a gain and impedance matching control circuit having an output coupled to the adjustable load component and the adjustable feedback component.

2. The amplifier circuitry of claim 1, wherein:

   the adjustable load component comprises an adjustable load capacitance coupled between the output of the amplifier and the ground power supply line; and
   the adjustable feedback component comprises an adjustable feedback capacitance coupled between the output and the input of the amplifier.

3. The amplifier circuitry of claim 1, wherein:

   the adjustable load component comprises an adjustable load inductance coupled between the output of the amplifier and the ground power supply line; and
   the adjustable feedback component comprises an adjustable feedback inductance coupled between the output and the input of the amplifier.

4. The amplifier circuitry of claim 1, wherein:

   the adjustable load component comprises an adjustable load resistance coupled between the output of the amplifier and the ground power supply line; and
   the adjustable feedback component comprises an adjustable feedback resistance coupled between the output and the input of the amplifier.

5. The amplifier circuitry of claim 1, wherein:

   the adjustable load component comprises an adjustable load capacitance coupled between the output of the amplifier and the ground power supply line; and
   the adjustable feedback component comprises an adjustable feedback inductance coupled between the output and the input of the amplifier.

6. The amplifier circuitry of claim 1, wherein:

   the adjustable load component comprises an adjustable load inductance coupled between the output of the amplifier and the ground power supply line; and
   the adjustable feedback component comprises an adjustable feedback capacitance coupled between the output and the input of the amplifier.

7. The amplifier circuitry of any preceding claim, wherein the gain and impedance matching control circuit is configured to:

   control a gain of the amplifier circuitry by adjusting the adjustable load component; and
   maintain an input resistance of the amplifier circuitry at a target level by adjusting the adjustable feedback component.

8. The amplifier circuitry of any preceding claim, wherein the gain and impedance matching control circuit is configured to generate control signals at its output for adjusting a gain of the amplifier circuitry without changing an amount of current flowing through the amplifier.

9. The amplifier circuitry of any of claims 1 to 4, wherein the adjustable load component and the adjustable feedback component are the same type of components and wherein the gain and impedance matching control circuit is configured to:

   set a ratio of a value of the adjustable load component to a value of the adjustable feedback component to a predetermined constant when the amplifier circuitry is operated at a first gain mode; and
   set the ratio to the predetermined constant when the amplifier circuitry is operated at a second gain mode different than the first gain mode.

10. The amplifier circuitry of any of claims 1, 5 or 6, wherein the adjustable load component and the adjustable feedback component are different types of components and wherein the gain and impedance matching control circuit is configured to:

   set a product of a value of the adjustable load component and a value of the adjustable feedback component to a predetermined constant when the amplifier circuitry is operated at a first gain mode; and
   set the product to the predetermined constant when the amplifier circuitry is operated at a second gain mode different than the first gain mode.

11. The amplifier circuitry of any preceding claim, wherein the amplifier has an output impedance that is at least two times greater than an impedance of the adjustable load component, and wherein the amplifier comprises a transconductance amplifier having an output impedance that is at least five times greater than the impedance of the adjustable load component.

12. A method of operating amplifier circuitry, the method comprising:

   receiving at an input of an amplifier a radio-frequency signal;
   outputting at an output of the amplifier an amplified signal to a mixer; and
   adjusting an adjustable load component coupled to the output of the amplifier to tune a gain of the amplifier circuitry while adjusting an adjustable feedback component coupled across the output and the input of the amplifier to set an input resistance of the amplifier circuitry.

13. The method of claim 12, further comprising:
   tuning the gain of the amplifier circuitry without changing a transconductance of the amplifier.

14. The method of claim 12, wherein the adjustable load component and the adjustable feedback component are the same type of adjustable electrical components, the method further comprising:

   setting a ratio of a value of the adjustable load component to a value of the adjustable feedback component to a predetermined constant when the amplifier circuitry is operated in a first gain mode;
   setting the ratio to the predetermined constant when the amplifier circuitry is operated in a second gain mode different than the first gain mode; and
   setting the ratio to the predetermined constant when the amplifier circuitry is operated in a third gain mode different than the first and second gain modes.

15. The method of claim 12, wherein the adjustable load component and the adjustable feedback component are different types of adjustable electrical components, the method further comprising:

   setting a product of a value of the adjustable load component and a value of the adjustable feedback component to a predetermined constant when the amplifier circuitry is operated in a first gain mode;
   setting the product to the predetermined constant when the amplifier circuitry is operated in a second gain mode different than the first gain mode; and
   setting the product to the predetermined constant when the amplifier circuitry is operated in a third gain mode different than the first and second gain modes.

EP 4 148 994 A1

10

ELECTRONIC DEVICE — 12

CONTROL CIRCUITRY — 14

STORAGE CIRCUITRY — 16

PROCESSING CIRCUITRY — 18

INPUT-OUTPUT CIRCUITRY — 20

INPUT-OUTPUT DEVICES
(E.G., SENSORS,
DISPLAYS, SPEAKERS,
MICROPHONES, ETC.) — 22

WIRELESS
COMMUNICATIONS
CIRCUITRY — 24

*FIG. 1*

15

24

ANTENNA(S) — 42 · · ·

36

FRONT END MODULE — 40

FILTER CIRCUITRY — 44

SWITCHING CIRCUITRY — 46 · · ·

AMPLIFIER CIRCUITRY — 48

50 — PA (S)     LNA (S) — 52

⋮

36

TRANSCEIVER CIRCUITRY — 28 · · ·

30 — TX     RX — 32

34

BASEBAND PROCESSOR — 26 · · ·

*FIG. 2*

*FIG. 3*

80

| GAIN SETTING | $C_L$ | $C_F$ | $R_{in}$ |
|---|---|---|---|
| 1 | $C_{L1}$ | $C_{F1}$ | $R_{in}$ _ target |
| 2 | $C_{L2}$ | $C_{F2}$ | $R_{in}$ _ target |
| 3 | $C_{L3}$ | $C_{F3}$ | $R_{in}$ _ target |
| 4 | $C_{L4}$ | $C_{F4}$ | $R_{in}$ _ target |
| ⋮ | | | |

*FIG. 4*

FIG. 5

**FIG. 6**

*FIG. 7*

**FIG. 8**

RECEIVE RADIO-FREQUENCY INPUT SIGNAL AT ANTENNA — 90

DETECT CHANGE IN RADIO-FREQUENCY INPUT SIGNAL — 92

DETERMINE SUITABLE GAIN SETTING TO ACCOMMODATE THE DETECTED CHANGE — 94

ADJUST $Z_L$ TO REALIZE NEW GAIN SETTING WHILE ADJUSTING $Z_F$ TO MAINTAIN INPUT MATCHING (WITHOUT CHANGING AMPLIFIER CURRENT) — 96

98

*FIG. 9*

**EP 4 148 994 A1**

## EUROPEAN SEARCH REPORT

Application Number

EP 22 19 0440

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 5 109895 B2 (FUJITSU LTD) 26 December 2012 (2012-12-26) * Equations 1,2; paragraphs [0015], [0021] – [0023]; figures 3,6,7 * | 1-15 | INV. H03G3/30 H03F1/56 H04B1/06 H04B1/18 |
| X | US 2008/055005 A1 (NAM IL-KU [KR] ET AL) 6 March 2008 (2008-03-06) * paragraphs [0030], [0049], [0053], [0054]; figure 1 * | 1,12 | |
| X | US 7 821 335 B2 (RENESAS ELECTRONICS CORP [JP]) 26 October 2010 (2010-10-26) * column 4, line 62 – column 5, line 38; figure 1 * | 1,12 | |

TECHNICAL FIELDS SEARCHED (IPC)

H03G
H03F
H04B

The present search report has been drawn up for all claims

| Place of search | Date of completion of the search | Examiner |
|---|---|---|
| The Hague | 31 January 2023 | Galardi, Leonardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 19 0440

This annex lists the patent family members relating to the patent documents cited in the above-mentioned European search report.
The members are as contained in the European Patent Office EDP file on
The European Patent Office is in no way liable for these particulars which are merely given for the purpose of information.

31-01-2023

| Patent document cited in search report | | Publication date | Patent family member(s) | | Publication date |
|---|---|---|---|---|---|
| JP 5109895 | B2 | 26-12-2012 | JP 5109895 B2 | | 26-12-2012 |
| | | | JP 2010074501 A | | 02-04-2010 |
| US 2008055005 | A1 | 06-03-2008 | KR 100705326 B1 | | 10-04-2007 |
| | | | US 2008055005 A1 | | 06-03-2008 |
| US 7821335 | B2 | 26-10-2010 | CN 101414805 A | | 22-04-2009 |
| | | | JP 2009100337 A | | 07-05-2009 |
| | | | US 2009102552 A1 | | 23-04-2009 |

EPO FORM P0459

For more details about this annex : see Official Journal of the European Patent Office, No. 12/82

**EP 4 148 994 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 75090922
- US 63243613